# EUROPÄISCHE PATENTANMELDUNG

(11) **EP 2 555 606 A1**
(43) Veröffentlichungstag der Anmeldung: **06.02.2013**
(21) Anmeldenummer: 11176383.5
(22) Anmeldetag: 03.08.2011
(51) Int. Cl.: H05K 7/20

(54) **Kühlungsanordnung zum Kühlen eines Stromrichtermoduls**

(71) Anmelder: SIEMENS AKTIENGESELLSCHAFT, 80333 München (DE)
(72) Erfinder: Bakran, Mark-Matthias, 91052 Erlangen (DE)

(57) **Zusammenfassung**

Die Erfindung betrifft eine Kühlungsanordnung (101) und ein Verfahren zum Kühlen eines Stromrichtermoduls (100), mit einem Stromrichterkomponenten (110) aufnehmenden Gehäuse (102) mit einem von einer Gehäusewandung (103) umgebenen Gehäuseinnenraum (104), der mit einem dielektrischen Fluid (105) befüllt ist, mit einer ersten Kühlstruktur (120,220) in einem ersten Teil (121) der Gehäusewandung (103), und mit einer zweiten Kühlstruktur (130,230) in einem zweiten Teil (131) der Gehäusewandung (103), wobei die oder jene Kühlstruktur (121,131) dazu ausgestaltet ist, das dielektrische Fluid (105) rückzukühlen.

## Beschreibung

Die Erfindung betrifft eine Kühlungsanordnung zum Kühlen eines Stromrichtermoduls und ein Verfahren zur Kühlung eines Stromrichtermoduls, welche zur Verwendung bei einem Elektro-und/oder Hybridfahrzeug geeignet sind.

Üblicherweise erzeugen gewisse Halbleitereinrichtungen im Betrieb übermäßige Wärme. Dies trifft besonders auf Leistungshalbleitereinrichtungen zu, welche üblicherweise als Schalter oder Gleichrichter bei elektrischen Hochleistungsschaltungen verwendet werden. Beispielsweise werden Wechselrichter bei Elektro- und Hybridelektrofahrzeugen eingesetzt, um den elektrischen Antriebsmotor des Fahrzeugs mit einer dreiphasigen Betriebsspannung zu versorgen. Wechselrichter und andere derartige Einrichtungen müssen typischerweise gekühlt werden, um eine korrekte Funktion sicherzustellen. Aus diesem Grund sind Leistungsmodule, in welchen derartige Leistungseinrichtungen untergebracht sind, oft mit irgendeiner Form von Kühlungssystem ausgestattet.

Die DE 10 2007 050 417 A1 offenbart ein Leistungsmodul mit einem in sich geschlossenen Kühlungssystem. Das Leistungsmodul umfasst ein Gehäuse mit einem Hohlraum darin und eine Halbleitereinrichtung, die in dem Hohlraum liegt. Das Kühlungssystem, das ebenso wie ein dielektrisches Fluid in dem Gehäuse angeordnet ist, umfasst einen Strömungsdurchgang, der durch das Gehäuse hindurch verläuft. Der Strömungsdurchgang ist mit dem Hohlraum fluidtechnisch gekoppelt und das Kühlungssystem ist ausgestaltet, um das dielektrische Fluid durch den Strömungsdurchgang hindurch und auf die Halbleitereinrichtung zirkulieren zu lassen. Zur Kühlung des dielektrischen Fluids ist unterhalb des Strömungsdurchgangs ein Kühlkörper angeordnet, der geeignet ist, Wärme von dem Modul abzuführen.

Ein Kühlungssystem des voranstehend beschriebenen Typs erreicht jedoch nur eine suboptimale Kühlung der Leistungseinrichtung aufgrund der geringen Wärmeabgabe des Kühlkörpers.

Die DE 10 2007 014 387 A1 offenbart eine Kühlungsanordnung zum Kühlen eines Umrichterschaltkreises. Die Anordnung umfasst ein Gehäuse, das ein Fach mit einem Raum aufweist, der Komponenten von Umrichterschaltkreisen enthält. Das Fach weist eine Einlassöffnung und eine Auslassöffnung für ein Kühlfluid auf, das mit dem Raum in Verbindung steht. Das Kühlfluid wird durch eine Pumpe in einem flüssigen Phasenzustand in den Raum und auf die Komponenten der Umrichterschaltkreise verteilt. Das durch die Erwärmung verdampfte Kühlmittel wird anschließend durch einen Wärmetauscher geleitet, welcher ein zweites Kühlmittel verwendet, um das verdampfte Kühlmittel wieder zu kondensieren, bevor das verwendete Fluid in dem flüssigen Phasenzustand erneut auf die Leistungselektronik-Komponenten aufgebracht wird. Die vorstehend beschriebene Kühlungsanordnung weist einen komplexen Aufbau auf und kann nicht auf kleinem Raum angeordnet werden.

Es ist daher Aufgabe der Erfindung, ein Verfahren und eine Kühlungsanordnung, insbesondere zum Kühlen eines Stromrichtermoduls, anzugeben, welche bei verbesserter Kühlleistung auf möglichst geringem Raum angeordnet werden kann.

Bezüglich der Kühlungsanordnung, insbesondere einer Kühlungsanordnung zum Kühlen eines Stromrichtermoduls der eingangs genannten Art, wird die genannte Aufgabe erfindungsgemäß dadurch gelöst, dass die Kühlungsanordnung ein Stromrichterkomponenten aufnehmendes Gehäuse mit einem von einer Gehäusewandung umgebenen Gehäuseinnenraum aufweist, der mit einem dielektrischen Fluid befüllt ist. In einem ersten Teil der Gehäusewandung kann hierbei eine erste Kühlstruktur und in einem zweiten Teil der Gehäusewandung eine zweite Kühlstruktur angeordnet sein, wobei die oder jene Kühlstruktur dazu ausgestaltet sein kann, das dielektrische Fluid rückzukühlen.

Die Kombination der ersten und zweiten Kühlstruktur mit dem dielektrischen Fluid als internes Kühlmedium ist eine Verbesserung der Kühlleistung ermöglicht. Durch die Anordnung der ersten und zweiten Kühlstruktur in jeweiligen Gehäusewandungen des Gehäuses des Stromrichtermoduls wird zudem die Unterbringung der Kühlanordnung auf geringem Raum erreicht. Durch die isolierende Eigenschaft des dielektrischen Fluids als Kühlmedium können zudem die Abstände intern minimiert und somit die Baugröße der jeweiligen Stromrichterkomponenten reduziert werden.

Gemäß einer vorteilhaften Weiterbildung ist vorgesehen, dass die erste und zweite Kühlstruktur zumindest jeweils einen Kühlkanal aufweisen, welcher Wasser durchflossen ist. Somit kann eine effektive Kühlung des Stromrichtermoduls erfolgen.

In zweckmäßiger Weise ist zudem vorgesehen, dass der Kühlkanal mit einem Rückkühlsystem verbunden ist. Es kommt somit zu einer Zirkulation des im Kühlkanal vorhandenen Kühlmediums, was eine konstante Temperatur des Kühlmediums sowie eine Wärmeaufnahme durch das Kühlmedium gewährleistet.

Gemäß einer weiteren bevorzugten Ausführungsform besteht zumindest die erste Kühlstruktur oder die zweite Kühlstruktur aus einem Kühlkörper oder einer Wärmesenke. Die Verwendung eines Kühlkörpers oder einer Wärmesenke ist insbesondere dann vorteilhaft, wenn das Gehäuse an einer Position im Fahrzeug angeordnet ist, welche eine effektive Wärmeabgabe an die Umgebungsluft ermöglicht.

Vorzugsweise bildet die zweite Kühlstruktur eine Kondensations- und Rückkühlfläche zum Verflüssigen des dielektrischen Fluids, das beim Absorbieren von Wärme der Stromrichter-Komponenten von einem flüssigen in einen gasförmigen Phasenzustand übergegangen ist. Eine solche Anordnung ermöglicht eine Siedekühlung der Stromrichterkomponenten in einem in sich geschlossenen Stromrichtermodul und kann somit im Vergleich zu konkurrierenden Kühlungsmethoden wie beispielsweise der Wärmeleitung, Konvektion, oder Wärmestrahlung dem zu kühlenden Objekt wirkungsvoller Wärme entziehen.

Gemäß einer geeigneten Ausgestaltung weist das dielektrische Fluid einen Siedepunkt zwischen 45°C und 70°C auf. Bei der Siedekühlung verdampft die Siedflüssigkeit an der heißen Oberfläche der Stromrichterkomponenten und benötigt dazu viel Wärmeenergie, was wiederum für eine sehr effektive Kühlung der Stromrichterkomponenten sorgt. Durch den geringen Siedepunkt verdampft das dielektrische Fluid bereits bei einer geringen Temperatur, wodurch der Effekt der Siedekühlung bereits bei niedrigen Temperaturen genutzt werden kann.

Das Gehäuse des Stromrichtermoduls ist vorteilhafter Weise aus einem wärmeleitenden Substrat ausgebildet. Somit kann eine effektive Wärmeübertragung von dem Leistungshalbleiter sowie der Siedflüssigkeit auf die Kühlstrukturen erreicht werden.

In zweckmäßiger Weiterbildung ist vorgesehen, dass das in dem Gehäuseinnenraum angeordnete Fluid in dem Gehäuseinnenraum ruht. Das Stromrichtermodul mit der Kühlungsanordnung ist somit ein in sich geschlossenes System und kann auf geringem Raum angeordnet werden.

Bezüglich des Verfahrens wird die genannte Aufgabe erfindungsgemäß dadurch gelöst, dass zur Kühlung eines Stromrichtermoduls ein Siedekühlen von in einem Gehäuseinnenraum eines Gehäuses des Stromrichtermoduls angeordneten Stromrichterkomponenten durch Verdampfen eines in dem Gehäuseinnenraum angeordneten dielektrischen Fluids bei Absorption von Wärme der Stromrichterkomponenten und anschließendem Verflüssigen des dielektrischen Fluids erfolgt, das beim Absorbieren von Wärme der Stromrichterkomponenten von einem flüssigen in einen gasförmigen Phasenzustand übergegangen ist. Des Weiteren kann ein Rückkühlen des dielektrischen Fluids durch eine in einem ersten Teil einer Gehäusewandung angeordnete erste Kühlstruktur und eine in einem zweiten Teil der Gehäusewandung angeordnete zweite Kühlstruktur erfolgen.

Die Kombination der Siedekühlung der Stromrichterkomponenten unter Verwendung des dielektrischen Fluids mit dem Rückkühlen des dielektrischen Fluids durch die in dem ersten Teil der Gehäusewandung angeordnete erste Kühlstruktur und die in dem zweiten Teil der Gehäusewandung angeordnete zweite Kühlstruktur kann ermöglicht eine Verbesserung der Kühlleistung. Durch die Anordnung der ersten und zweiten Kühlstruktur in jeweiligen Gehäusewandungen des Gehäuses des Stromrichtermoduls kann zudem die Unterbringung der Kühlanordnung auf geringem Raum erreicht werden.

Das Verflüssigen des dielektrischen Fluids wird in vorteilhafter Weise an einer Kondensations- und Rückkühlfläche der zweiten Kühlstruktur durchgeführt. Dies ermöglicht eine Siedekühlung der Stromrichterkomponenten in einem in sich geschlossenen Stromrichtermodul und kann somit im Vergleich zu anderen Kühlungsmethoden, wie beispielsweise der Wärmeleitung, Konvektion, oder Wärmestrahlung, dem zu kühlenden Objekt vergleichsweise wirkungsvoll Wärme entziehen.

Nachfolgend werden Ausführungsbeispiele der Erfindung anhand einer Zeichnung näher erläutert. Darin zeigen:
- FIG 1: eine schematische Darstellung eines ersten Ausführungsbeispiels einer erfindungsgemäßen Kühlungsanordnung in einer Schnittansicht, und
- FIG 2: eine schematische Darstellung zweiten ersten Ausführungsbeispiels einer erfindungsgemäßen Kühlungsanordnung in einer Schnittansicht.

Einander entsprechende Teile sind in beiden Figuren mit den gleichen oder ähnlichen Bezugszeichen versehen.

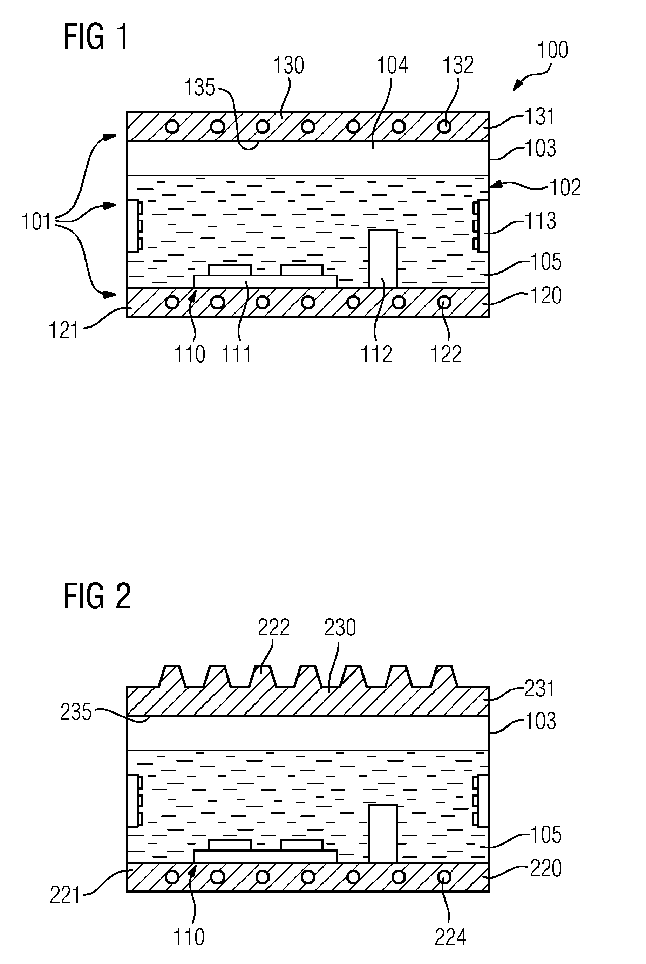

FIG 1 zeigt eine schematische Darstellung eines ersten Ausführungsbeispiels einer Kühlungsanordnung 101 in einer Schnittansicht. Hierbei ist die Kühlungsanordnung 101 in einem Stromrichtermodul 100 angeordnet. Das Stromrichtermodul 100 ist hermetisch abgedichtet und weist ein Gehäuse 102 auf. Das Gehäuse 102 besteht aus einer Gehäusewandung 103, wobei die Gehäusewandung 103 einen ersten Teil 121 und einen zweiten Teil 131 sowie einen Gehäuseinnenraum 104 aufweist. In dem Gehäuse 102 sind ferner Stromrichterkomponenten 110 angeordnet und der Gehäuseinnenraum 104 ist mit einem dielektrischen Fluid 105 befüllt.

Der erste Teil 121 des Gehäuses 102 (erstes Gehäuseteil 121) ist durch eine Bodenplatte gebildet und nimmt eine erste Kühlstruktur 120 auf. Die erste Kühlstruktur 120 weist hierbei einen Kühlkanal 122 auf, welcher Wasser durchflossen ist. Der Kühlkanal 122 ist mit einem (nicht dargestellten) Rückkühlsystem verbunden. Das Rückkühlsystem besteht im Wesentlichen aus einem Motorkühler und einer Pumpe zur Zirkulation des Kühlwassers.

Die zweite Kühlstruktur 130 weist einen Kühlkanal 132 auf, welcher Wasser durchflossen ist. Der Kühlkanal 132 ist ebenfalls mit dem Rückkühlsystem verbunden. Das Gehäuse 102 weist hierfür einen (nicht gezeigten) Anschluss zur Verbindung der Kühlkanäle 122, 132 mit dem Rückkühlsystem auf.

Die Stromrichterkomponenten 110 umfassen ein Leistungshalbleitermodul 111, passive Komponenten, wie beispielsweise einen Zwischenkreis-Kondensator, sowie Elektronik-Baugruppen 113. Die Leistungshalbleiter 111 und die passiven Komponenten 112 sind hierbei auf dem ersten Gehäuseteil 121, d.h. der Bodenplatte angeordnet, wohingegen die Elektronik-Baugruppen 113 auf vorzugsweise rechtwinklig zu der Bodenplatte angeordneten Seitenwänden der Gehäusewandung 103 befestigt sind.

Das Kühlmedium weist einen Siedepunkt zwischen 45°C und 70°C auf. Beispiele hierfür sind Novec™ 649 oder auch FC-3284. Bevorzugt ist eine Kombination von Wasser als Rückkühlmedium und Siedflüssigkeit bzw. dielektrisches Fluid 105 als internes Kühlmedium vorgesehen.

Es erfolgt ein Siedekühlen der in dem Gehäuseinnenraum 104 des Gehäuses 102 des Stromrichtermoduls 100 angeordneten Stromrichterkomponenten 110 durch Verdampfen des in dem Gehäuseinnenraum 104 angeordneten dielektrischen Fluids 105 bei Absorption von Wärme der Stromrichterkomponenten 110 und anschließendes Verflüssigen des dielektrischen Fluids 105, das beim Absorbieren von Wärme der Stromrichterkomponenten 110 von einem flüssigen in einen gasförmigen Phasenzustand übergegangen ist. Das Verflüssigen des gasförmigen dielektrischen Fluids 105 erfolgt an einer Kondensations- und Rückkühlfläche 135 der zweiten Kühlstruktur 130. Die Kondensations- und Rückkühlfläche 135 ist hierbei durch eine gehäuseinnenraumseitige Wand der Kühlstruktur 130 ausgebildet. Des Weiteren erfolgt ein Rückkühlen des dielektrischen Fluids 105 durch eine erste in dem ersten Teil 121 einer Gehäusewandung 103 angeordnete Kühlstruktur 120 und eine zweite in einem zweiten Teil 131 der Gehäusewandung angeordnete Kühlstruktur 130.

Das Leistungshalbleitermodul 111, welches normalerweise in einem Verguss hergestellt ist, kann bei dieser Anordnung offen bleiben, da das dielektrische Fluid 105 die Funktion der Isolation ebenso erfüllt. Damit können die Leistungshalbleiter-Chips die Verluste nicht nur nach unten in das Wasser, sondern auch nach oben in das dielektrische Fluid 105 abgeben.

FIG 2 zeigt eine schematische Darstellung eines zweiten Ausführungsbeispiels einer Kühlungsanordnung 101 in einer Schnittansicht. Die erste Kühlstruktur 220 weist hier einen Kühlkanal 224 auf, welcher Wasser durchflossen ist, während die zweite Kühlstruktur 230 aus einem Kühlkörper 222 mit einer Mehrzahl von Kühlrippen besteht. Es erfolgt somit eine Wärmeabgabe des Kühlkörpers 222 an die Umgebungsluft. Die zweite Kühlstruktur 230 weist - wie mit Bezug auf das erste Ausführungsbeispiel beschrieben - eine Kondensations- und Rückkühlfläche 235 auf, an welcher ein Verflüssigen des dielektrischen Fluids 105 erfolgt, das beim Absorbieren von Wärme der Stromrichterkomponenten 110 von einem flüssigen in einen gasförmigen Phasenzustand übergegangen ist.

Des Weiteren erfolgt ein Rückkühlen des dielektrischen Fluids 105 durch die in dem ersten Teil 221 einer Gehäusewandung 103 angeordnete erste Kühlstruktur 220 und eine in einem zweiten Teil 231 der Gehäusewandung angeordnete zweite Kühlstruktur 230.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

## Patentansprüche

1. Kühlungsanordnung (101) zum Kühlen eines Stromrichtermoduls (100), mit einem Stromrichterkomponenten (110) aufnehmenden Gehäuse (102) mit einem von einer Gehäusewandung (103) umgebenen Gehäuseinnenraum (104), der mit einem dielektrischen Fluid (105) befüllt ist, mit einer ersten Kühlstruktur (120,220) in einem ersten Teil (121) der Gehäusewandung (103), und mit einer zweiten Kühlstruktur (130,230) in einem zweiten Teil (131) der Gehäusewandung (103), wobei die oder jene Kühlstruktur (121,131) dazu ausgestaltet ist, das dielektrische Fluid (105) rückzukühlen.

2. Kühlungsanordnung nach Anspruch 1, wobei die erste und zweite Kühlstruktur (120,130) zumindest jeweils einen Kühlkanal (122,132) aufweisen, welcher Wasser durchflossen ist.

3. Kühlungsanordnung nach Anspruch 2, wobei der Kühlkanal (122,132) mit einem Rückkühlsystem verbunden ist.

4. Kühlungsanordnung nach Anspruch 1, wobei zumindest die erste Kühlstruktur (220) oder die zweite Kühlstruktur (230) aus einem Kühlkörper (222) oder einer Wärmesenke besteht.

5. Kühlungsanordnung nach Anspruch 1 oder 2, wobei die zweite Kühlstruktur (130) eine Kondensations- und Rückkühlfläche (135) zum Verflüssigen des dielektrischen Fluids (105) bildet, das beim Absorbieren von Wärme der Stromrichterkomponenten (110) von einem flüssigen in einen gasförmigen Phasenzustand übergegangen ist.

6. Kühlungsanordnung nach einem der vorhergehenden Ansprüche, wobei das dielektrische Fluid (105) einen Siedepunkt zwischen 45 und 70°C aufweist.

7. Kühlungsanordnung nach einem der vorhergehenden Ansprüche, wobei das Gehäuse (102) des Stromrichtermoduls (100) aus einem wärmeleitenden Substrat ausgebildet ist.

8. Kühlungsanordnung nach einem der vorhergehenden Ansprüche, wobei das in dem Gehäuseinnenraum (104) angeordnete dielektrische Fluid (105) in dem Gehäuseinnenraum ruht.

9. Verfahren zur Kühlung eines Stromrichtermoduls (100) **gekennzeichnet durch**
- ein Siedekühlen von in einem Gehäuseinnenraum (104) eines Gehäuses (102) eines Stromrichtermoduls (100) angeordneten Stromrichterkomponenten (110) **durch** Verdampfen eines in dem Gehäuseinnenraum (104) angeordneten dielektrischen Fluids (105) bei Absorption von Wärme der Stromrichterkomponenten (110) und anschließendes Verflüssigen des dielektrischen Fluids (105), das beim Absorbieren von Wärme der Stromrichterkomponenten (110) von einem flüssigen in einen gasförmigen Phasenzustand übergegangen ist, und
- ein Rückkühlen des dielektrischen Fluids (105) **durch** eine in einem ersten Teil (121) einer Gehäusewandung (103) angeordnete erste Kühlstruktur (120,220) und eine in einem zweiten Teil (131) der Gehäusewandung angeordnete zweite Kühlstruktur (130,230).

10. Verfahren nach Anspruch 9, wobei das Verflüssigen des dielektrischen Fluids (105) an einer Kondensations- und Rückkühlfläche (135) der zweiten Kühlstruktur (130) durchgeführt wird.
